**Europäisches Patentamt**

**European Patent Office**

**Office européen des brevets**

(11) Publication number: **0 025 316**
**B1**

(12) **EUROPEAN PATENT SPECIFICATION**

(45) Date of publication of patent specification: **05.11.86**

(21) Application number: **80302981.8**

(22) Date of filing: **28.08.80**

(51) Int. Cl.⁴: **G 11 C 8/00, G 11 C 11/40**

(54) **A termination circuit for word lines of a semiconductor memory device.**

(30) Priority: **30.08.79 JP 110720/79**

(43) Date of publication of application:
**18.03.81 Bulletin 81/11**

(45) Publication of the grant of the patent:
**05.11.86 Bulletin 86/45**

(84) Designated Contracting States:
**DE FR GB NL**

(56) References cited:
**US-A-4 156 941**

(73) Proprietor: **FUJITSU LIMITED**
**1015, Kamikodanaka Nakahara-ku**
**Kawasaki-shi Kanagawa 211 (JP)**

(72) Inventor: **Takahashi, Yukio**
**528 Kozuhara Ibuki-cho**
**Sakata-gun Shiga 521-04 (JP)**

(74) Representative: **Abbott, Leonard Charles et al**
**GILL JENNINGS & EVERY 53-64 Chancery Lane**
**London WC2A 1HN (GB)**

The file contains technical information submitted after the application was filed and not included in this specification

Courier Press, Leamington Spa, England.

## Description

The present invention relates to a termination circuit for word lines of a semiconductor memory device, more particularly to a termination circuit which can reduce both a rise time and a fall time of a word selection signal applied to the word lines.

In general, it is necessary to decrease the power consumption of each memory cell and to decrease the size of each memory cell in order to increase the capacity of a semiconductor memory device. One of the methods for decreasing the power consumption of each of the memory cells is to increase the resistance value of the load resistors of each of the memory cells so that a holding current passing through non-selected word lines is decreased. However, the increase of the resistance value of the load resistors leads to an increase of transition time from a selected condition to a non-selected condition, because the fall time of the word selection signal is increased. Consequently, high speed operation of the memory device can not be attained.

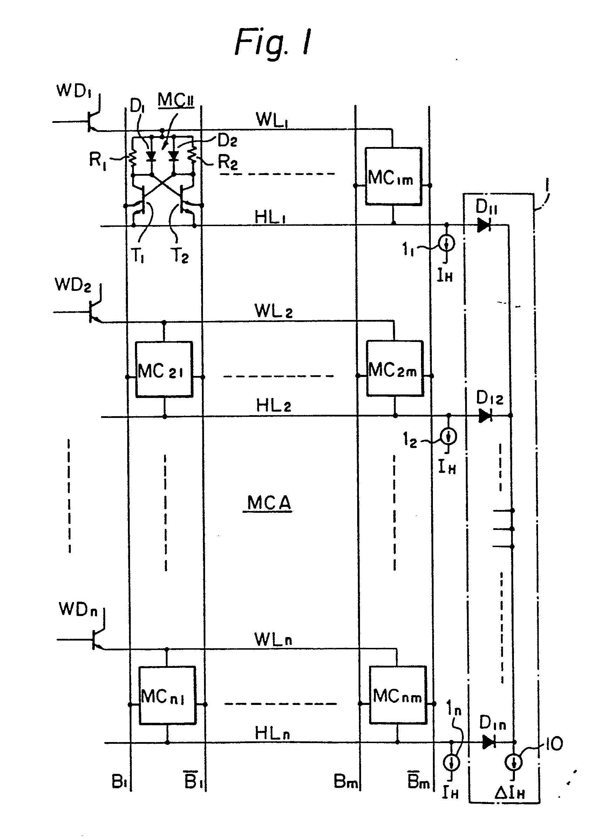

In order to decrease the fall time of the word selection signal applied to a word line, a conventional memory device, as disclosed in the thesis "An ECL LOOK Compatible 1024×4b RAM with 15 ns Access Time", by Ulf Buerker, et al, ISSCC Digest of Technical Papers, February 15, 1979, p. 102, comprises a termination circuit as illustrated in Fig. 1.

In Fig. 1, a memory cell array MCA which is composed of a plurality of memory cells $MC_{ij}$ (i=1, 2, . . ., n; j=1, 2, . . ., m) whose matrix is n rows by m columns is illustrated. Each of the memory cells $MC_{ij}$ is a well known flip-flop type cell. The memory cell, for example $MC_{11}$, comprises two multiemitter transistors $T_1$ and $T_2$, two load resistors $R_1$ and $R_2$, and, two diodes $D_1$ and $D_2$ which are connected parallel to the load resistors $R_1$ and $R_2$, respectively. One of the emitter electrodes of the multiemitter transistor $T_1$ is connected to a hold line $HL_1$ and the other emitter electrode of the multiemitter transistor $T_1$ is connected to a bit line $B_1$. One of the emitter electrodes of the multiemitter transistor $T_2$ is connected to the hold line $HL_1$ and the other emitter electrode of the multiemitter transistor $T_2$ is connected to a bit line $\bar{B}_1$. The word lines $WL_1$, $WL_2$, . . ., $WL_n$ are connected to word line drivers $WD_1$, $WD_2$, . . ., $WD_n$ respectively. The hold lines $HL_1$, $HL_2$ . . ., $HL_n$ are connected to hold current sources $I_1$, $I_2$, . . ., $I_n$ respectively. The hole lines $HL_1$, $HL_2$, . . ., $HL_n$ are also connected to anode electrode of diodes $D_{11}$, $D_{12}$, . . ., $D_{1n}$, respectively, of a termination circuit 1, and cathode electrodes of the diodes $D_{11}$, $D_{12}$, . . ., $D_{1n}$ are commonly connected to an additional current source 10.

One of the memory cells $MC_{ij}$, for example the memory cell $MC_{11}$, is selected due to the supply of a word selection signal of high potential to the word driver $WD_1$ and a bit selection signal of high potential to a bit line driver which is connected to the bit line pair $B_1$ and $\bar{B}_1$ and which is not shown in Fig. 1. Therefore, the potential of the selected work line is high, and the potential of the non-selected word lines is low. The potential of the hold line is lower than that of the corresponding word line by a nearly constant value, i.e., the base-emitter voltage of the transistor composing the memory cell.

The termination circuit 1 of the memory device of Fig. 1 helps to reduce the fall time of the potential of the word line, for example $WL_1$, when the word line changes its state from the selected condition to the non-selected condition, due to the addition of the current $\Delta I_H$ to the current $I_H$ flowing from the selected word line $WL_1$ through the memory cells $MC_{11}$, . . ., $MC_{1m}$ to the hold line $HL_1$. Since the potential level of the hold line $HL_1$, corresponding to the selected word line $WL_1$, is higher than that of the other hold lines $HL_2$, . . ., $HL_n$, the diode $D_{11}$ connected to the selected hold line $HL_1$ is turned on and the current $\Delta I_H$ flows from the selected hold line $HL_1$ through the diode $D_{11}$ to the additional current source 10. Consequently, the potential level of the hold line $HL_1$ and, thus the potential level of the word line $WL_1$ falls quickly. The additional current $\Delta I_H$ serves to quickly discharge the electric charge stored in stray capacitance included in the word line, the hold line and the memory cells connected between the word line and the hold line, so that the potential drop of the word line is accelerated.

In order to decrease an operation time, for example, the reading out time of the memory device, it is necessary to quickly lower the output potential of a non-selected memory cell. This is because a reading out current flows even from the non-selected memory cell to the bit line when the potential level of the non-selected memory cell is high, and read out from the next selected memory cell cannot be started before the potential level of the non-selected memory cell drops. The potential level of the non-selected memory cell does not fall quickly, even if the potential level of the word line falls quickly, due to the existence of the stray capacitance contained in the memory cell. Therefore, as mentioned above, the potential of the memory cell is forced to drop to a low level by using the additional current $\Delta I_H$ flowing from the memory cell through the hold line to the additional current source 10. It should be noted that the additional current is required to flow temporarily during the transition period from the selected condition to non-selected condition.

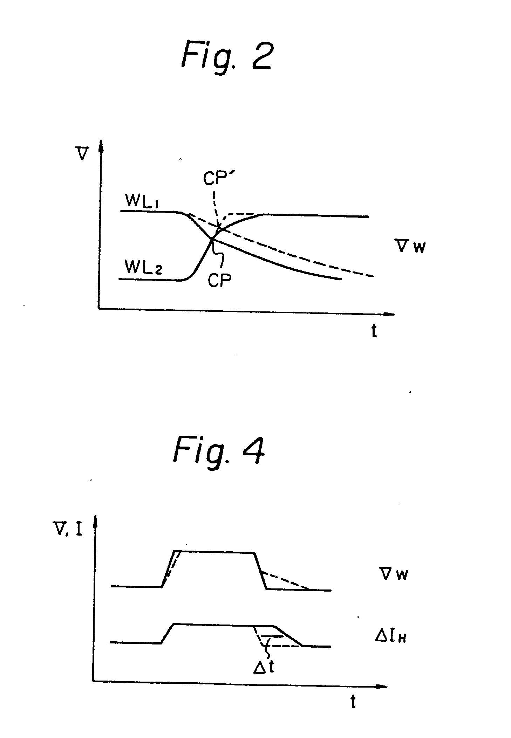

Fig. 2 illustrates the relationship between the potential of two word lines, one of which is, for example, the word line $WL_1$ which has been previously selected and which is changing its potential from high (selected condition) to low (non-selected condition), and; the other one of which is, for example, the word line $WL_2$ which has been selected after the word line $WL_1$ and which is changing its potential from low to high. The dotted lines illustrate the characteristics of the potential of the two word lines $WL_1$ and $WL_2$ when the termination circuit 1 of Fig. 1 is not used, and the solid lines illustrate that of the two word lines $WL_1$ and $WL_2$ when the termination circuit of Fig. 1 is used. As shown in Fig. 2, a cross point CP of the solid lines becomes faster than a cross point CP' of the dotted lines due to the effect of the termination circuit 1.

However, although the termination circuit 1 can reduce the fall time of the potential of the word line, for example, $WL_1$ until the cross point CP is reached, the fall time after the cross point CP cannot be reduced. This is because the additional current $\Delta I_H$ does not flow from the hold line $HL_1$ but flows from the hold line $HL_2$ to the additional current source 10 after the cross point CP. That is, among the diodes $D_{11}$, $D_{12}$, . . ., $D_{1n}$ of the termination circuit 1, only one diode which is connected to the hold line having the highest potential level turns on, and therefore, until the cross point CP is reached the diode $D_{11}$ is turned on, and after the cross point CP the diode $D_{12}$ is turned on. Therefore, until the cross point CP is reached, the additional current $\Delta I_H$ flows from the hold line $HL_1$, corresponding to the word line $WL_1$ which is previously selected, and after the cross point CP, the additional current $\Delta I_H$ flows from the hold line $HL_2$, corresponding to the word line $WL_2$ which is selected after the word line $WL_1$, so that only the hold current $I_H$ flows through the hold line $HL_1$.

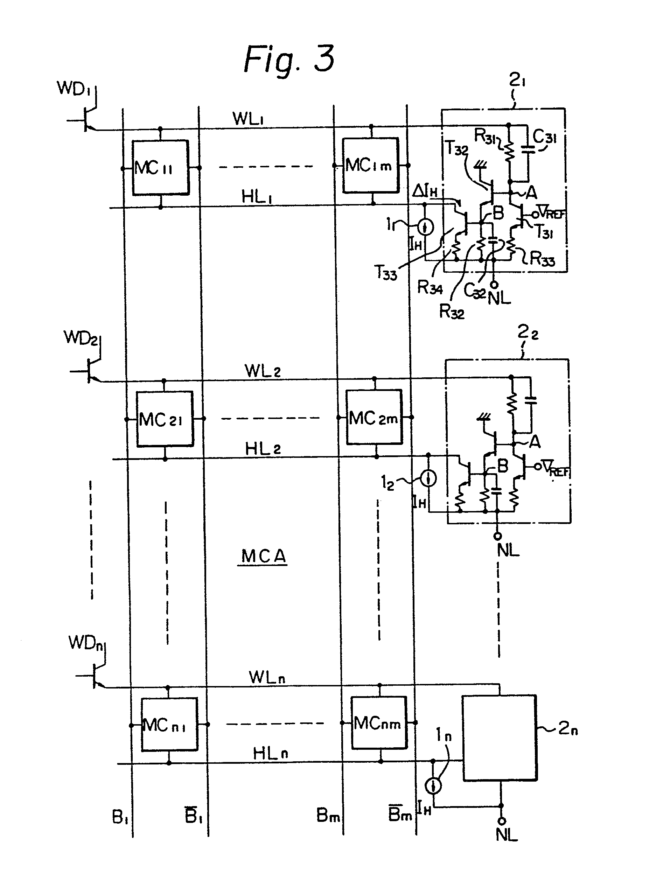

Fig. 3 illustrates other conventional termination circuits $2_1$, $2_2$, . . ., $2_n$, disclosed in the thesis "A 6 ns 4 Kb Bipolar RAM using Switched Load Resistor Memory Cell", by Masaaki Inadachi, et al, ISSCC Digest of Technical Papers, February 15, 1979, p. 108. The termination circuit, for example, $2_1$ reduces the fall time of the potential level of the word line $WL_1$ by delaying the trailing edge of the word selection signal on the word line $WL_1$ and not delaying the leading edge of the same, so that the additional current $\Delta I_H$ flows from the hold line $HL_1$, corresponding to the word line $WL_1$, to the current source $\Delta I_H$ until the potential level of the word line $WL_1$ falls to a substantially low level, even after the word line $WL_1$ has changed its state from the selected condition to the non-selected condition.

One of the termination circuits $2_1$, $2_2$, . . ., $2_n$ of Fig. 3, for example, the termination circuit $2_1$, comprises an NPN type transistor $T_{31}$, whose collector electrode is connected to the word line $WL_1$ through a parallel connection of a resistor $R_{31}$ and a capacitor $C_{31}$, whose emitter electrode is connected to a negative voltage source line NL through a resistor $R_{33}$ and whose base electrode is connected to a reference voltage source $V_{REF}$ having a constant voltage, so that the transistor $T_{31}$ operates as a constant current source. The termination circuit $2_1$ also comprises an NPN type transistor $T_{32}$, whose base electrode is connected to the collector electrode (point A) of the transistor $T_{31}$, whose collector electrode is connected to the ground and whose emitter electrode is connected to the negative voltage source line NL through a parallel connection of a resistor $R_{32}$ and a capacitor $C_{32}$. The termination

circuit $2_1$ further includes an NPN type transistor $T_{33}$, whose base electrode is connected to the emitter electrode (point B) of the transistor $T_{32}$ whose collector electrode is connected to the hold line $HL_1$ and whose emitter electrode is connected to the negative voltage source line NL through a resistor $R_{34}$.

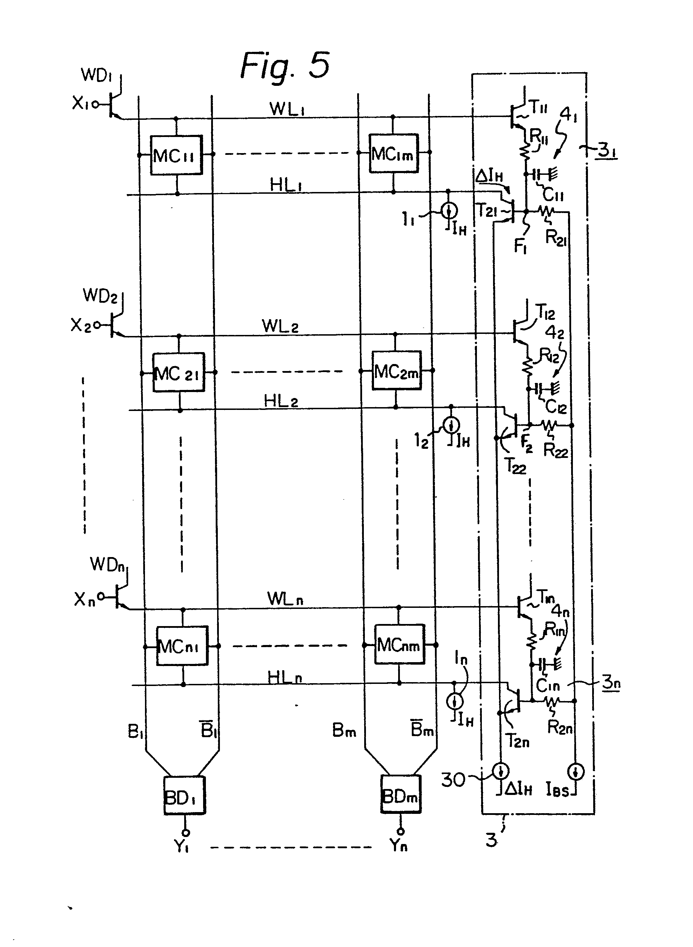

In the termination circuit $2_1$ of Fig. 3, the potential of point A rises substantially at the same time as the potential rise of the word line $WL_1$, due to the action of the capacitor $C_{31}$, and the potential of the point B, which is lower than the of the point A by a base-emitter voltage $V_{BE}$ of the transistor $T_{32}$, also rises at substantially the same time as the potential rise of the word line $WL_1$. Therefore, the transistor $T_{33}$ turns on immediately after the potential rise of the selected word line $WL_1$, and the additional current $\Delta I_H$ flows from the hold line $HL_1$ through the transistor $T_{33}$ and the resistor $R_{34}$ to the negative voltage source line NL. When the potential of the word line $WL_1$ drops, due to the transition of its state from the selected condition to the non-selected condition, the potential of the point B does not fall immediately but falls slowly, due to the action of the capacitor $C_{32}$, so that the transistor $T_{33}$ does not turn off immediately after the drop of the potential of the word line $WL_1$ but continues to be in a turned on condition for a short time. Therefore, as shown in Fig. 4, the additional current $\Delta I_H$ continues to flow through the hold line $HL_1$ for a predetermined time period $\Delta t$, even after the potential $V_W$ of the word line $WL_1$ has fallen from the high level (selected condition) to the low level (non-selected condition). Consequently, the fall time of the potential $V_W$ of the word line is reduced as shown by a solid line in Fig. 4. In Fig. 4, dotted lines show the characteristics of the potential $V_W$ of the word line and the additional current $\Delta I_H$ of the circuit of Fig. 1.

However, in the termination circuit $2_1$ of Fig. 3, the transistor $T_{33}$ turns on immediately after the potential rise of the word line $WL_1$ and the additional current $\Delta I_H$ flows through the hold line $HL_1$, corresponding to the word line $WL_1$, immediately. Therefore, the load of the word line $WL_1$, i.e., the load of the word line driver $WD_1$, becomes heavy during the potential rise of the word line $WL_1$, so that the rise time of the potential $V_W$ of the word line $WL_1$ is increased when the word line driver $WD_1$ does not have a large driving capability.

The termination circuits $2_1$, $2_2$, . . ., $2_n$ of Figure 3 also have the following disadvantages. That is, each of the termination circuits $2_1$, $2_2$, . . ., $2_n$ of Figure 3 uses many circuit parts, including two capacitors, for example, C31 and C32, so that the area occupied by each of the termination circuits $2_1$, $2_2$ . . ., $2_n$ in an integrated circuit of a memory device becomes large. It should be noted that a termination circuit $2_1$, $2_2$, . . ., $2_{n-1}$ or $2_n$ is provided for each of the word lines of a memory device and therefore, a memory device of, for example, 4 Kbits (64×64) bits), which has 64 word lines, needs 64 termination circuits, so that the area occupied by the termination circuits becomes very large.

US—A—4156941 also discloses semiconductor memory devices having termination units with delay circuits. One such circuit employs, for each row of memory cells, a signal detecting transistor circuit connected to the word line, a two-transistor delay circuit receiving the output of the detecting circuit, and a further transistor the base of which receives the delayed signal, the collector of which is connected to the hold line and the emitter of which is connected through a resistor to a DC voltage source. As this unit is repeated for each row of memory cells, a large number of components is involved; additionally, the basis potential of one transistor in the delay circuit is not linked to the voltage of the power supply, so that the delayed discharge current will be affected by power supply variations.

It is the principal object of the present invention to reduce the rise time and the fall time of the potentials of word lines of a memory device with a minimum of additional components.

The present invention consists in a semiconductor memory device having a plurality of memory cells, each of the memory cells being connected between a word line and a hold line, each of the word lines being selected by word address signals applied to the semiconductor memory device and being driven to different first or second potential levels with respect to a reference voltage in dependence upon the selected or non-selected condition of the word line, and each hold line having a hold line current source connected thereto, the semiconductor memory device further comprising a termination circuit comprising:—

first transistors each connected to one of the word lines for detecting a potential change of the word line with respect to a reference voltage, and each generating·a detection signal when a change in the potential of the corresponding word line occurs;

delay circuits, each connected to a respective one of the first transistors for delaying a detection signal generated by the said transistor for a predetermined period;

and second transistors, each of which has its base connected to a respective one of the delay circuits and its collector connected to a respective one of the hold lines, each second transistor being turned on and off by the delayed detection signal from its respective delay circuit, whereby when a word line changes from a selected condition to a non-selected condition, the current flowing through a memory cell from the word line to the hold line continues after the said change and the potential fall time for the said word line is reduced;

characterized in that a common hold current source is connected to the emitter of each of the second transistors, the said second transistors and the common hold current source thus forming a current switch, and in that each of the delay circuits comprises a resistor connected between an emitter electrode of the corresponding first transistor and the base electrode of the corresponding second transistor, and a capacitor connected between the base electrode of the corresponding second transistor and a reference voltage, and each of the said second transistors has its base connected through a further resistor to a common bias current source.

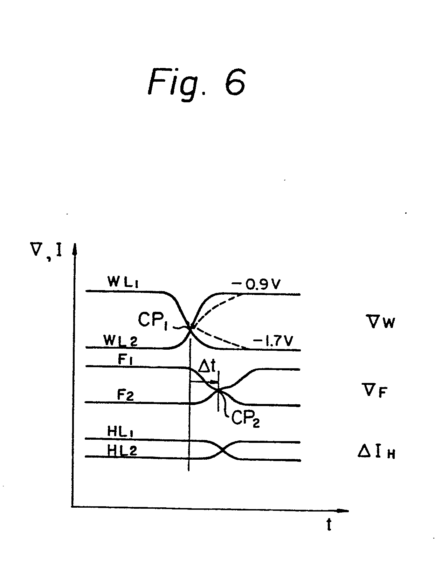

In order that the invention may be better understood, one embodiment of the invention will now be described with reference to Figures 5 and 6 of the accompanying drawings. In the drawings:

Figure 1, to which reference has already been made, illustrates a memory device having a conventional termination circuit;

Figure 2 is a timing diagram showing the potentials of the word lines in the memory device of Figure 1;

Figure 3 illustrates a memory device having other conventional termination circuits also described above;

Figure 4 is a timing diagram illustrating the potential $V_W$ of a word line and the additional current $\Delta I_H$ in the memory device of Figure 3;

Figure 5 illustrates a memory device having a termination circuit embodying the present invention.

Figure 6 is a timing diagram illustrating signals appearing in the memory device of Figure 5.

In Figure 5, parts which are the same as parts in Figure 2 of Figure 4 are designated by the same reference symbols.

In Figure 5, $X_1$, $X_2$, ..., $X_n$ designate word address signals which are applied to the word line driver $WD_1$, $WD_2$, ..., $WD_n$ and each of which becomes high in the selected condition. $Y_1$, $Y_2$, ... $Y_m$ designate bit address signals which are applied to bit line drivers $BD_1$, $BD_2$ ... $BD_m$ and each of which become high in the selected condition. One of the bit line drivers $BD_1$, $BD_2$ ... $BD_m$ to which a high level bit address signal is applied turns on. The termination circuit 3 embodying the present invention, comprises n termination circuits units $3_1$ to $3_n$, each of which is connected to end points of the corresponding one of the word lines $WL_1$ to $WL_n$ and of the corresponding one of the hold lines $HL_1$ to $HL_n$. Each of the termination circuit units $3_1$ to $3_n$ has the same structure, and therefore, only the termination circuit unit $3_1$ connected to the word line $WL_1$ and the hold line $HL_1$ will now be explained. The termination circuit unit $3_1$ comprises: a first NPN type transistor $T_{11}$, which operates as an emitter follower and whose base electrode is connected to the word line $WL_1$; a delay circuit $4_1$, which delays an output signal from the transistor $T_{11}$ and which consists of a resistor $R_{11}$ and a capacitor $C_{11}$; a second NPN type transistor $T_{21}$, which receives an output signal from the delay circuit $4_1$, whose collector electrode is connected to the hold line $HL_1$ and whose emitter electrode is connected commonly to a common hold current source 30, and; a

resistor $R_{21}$ connected between a base electrode of the transistor $T_{21}$ and a common bias current source $I_{BS}$. The resistors $R_{21}$ and $R_{11}$, and the common bias current source $I_{BS}$ determined a base bias potential of the transistor $T_{21}$. It should be noted that n NPN type transistors $T_{21}$ through $T_{2n}$ and the common hold current source 30 compose a current switch.

Operation of termination circuit 3 in Fig. 5 will now be described. When the word line, for example, $WL_1$ changes from selected condition to the non-selected condition or from the non-selected condition to the selected condition, the potential of the word line $WL_1$ changes from high level, for example $-0.9$ V, to low level, for example $-1.7$ V, or from low level to high level, respectively. Such a potential change is transferred to the base electrode of the transistor $T_{21}$ through the transistor $T_{11}$ and the delay circuit $4_1$ with a short delay determined by a time constant $R_{11} \cdot C_{11}$.

Assume that the word line, for example $WL_1$, has been previously selected and is changing its state from the selected condition to the non-selected condition, and the another word line, for example $WL_2$, has been selected after the word line $WL_1$ and is changing its state from the non-selected condition to the selected condition. In this condition, the potential $V_W$ of the word line $WL_1$ changes from high to low and the potential $V_W$ of the word line $WL_2$ changes from low to high as shown in Fig. 6. A potential $V_F$ of point $F_1$, that is, the output of the delay circuit $4_1$ changes from a relatively high level to a relatively low level with a short delay, and the potential $V_F$ of point $F_2$, that is, the output of the delay circuit $4_2$ changes from a relatively low level to a relatively high level with a short delay as shown in Fig. 6. Therefore, cross point $CP_2$ of the potentials of the points $F_1$ and $F_2$ is later than cross point $CP_1$ of the potentials of the word lines $WL_1$ and $WL_2$ by a delay time $\Delta t$, which is determined by the time constant $R_{11} \cdot C_{11}$. Practical experiments have shown that the delay time $\Delta t$ amounts to about 4 ns in the condition of $C_{11}=1$pF, $R_{11}=R_{21}=5$ KΩ and the delay time can be set to any value by selecting values of the capacitor $C_{11}$ and the resistors $R_{11}$ and $R_{21}$. Since the transistors $T_{21}$ through $T_{2n}$ compose the current switch, only one of the transistors $T_{21}$ through $T_{2n}$ which has the highest base potential is turned on at one time. Therefore, until the cross point $CP_2$ is reached, the transistor $T_{21}$ is in the turned on condition and the additional current $\Delta I_H$ flows from the hold line $HL_1$ through the transistor $T_{21}$ to the common hold current source 30, and, after the cross point $CP_2$ the transistor $T_{22}$ is turned on and the additional current $\Delta I_H$ flows from the hold line $HL_2$ through the transistor $T_{22}$ to the common hold current source 30.

Since the additional current $\Delta I_H$ continues to flow through the hold line $HL_1$ until a short time after the word line $WL_1$ has changed from the selected condition to the non-selected condition, the fall time of the potential of the word line $WL_1$ is reduced. Since the additional current $\Delta I_H$ does not flow through the hold line $HL_2$ immediately after the word line $WL_2$ has changed from the non-selected condition to the selected condition, too much current does not flow from the word line driver $WD_2$ through the word line $WL_2$ to the hold line $HL_2$ at the transition period of the potential of the word line $WL_2$ from low to high, so that the rise time of the potential of the word line $WL_2$ is reduced.

In the above described embodiment, the common bias current source $I_{BS}$, which is common to a plurality of termination circuit units $3_1$, through $3_n$, is used. However, it is also possible to use a plurality of bias current sources, each of which is connected to the base electrode of one of the transistors $T_{21}$ through $T_{2n}$ respectively.

In the above described embodiment, a switching point of the additional current $\Delta I_H$ is delayed from a switching point of the word line potential $V_W$ by using the delay circuit consisting, for example, the resistor $R_{11}$ and the capacitor $C_{11}$, so that both the rise time and the fall time of the word line potential can be reduced. Since the bias current $I_{BS}$ can be decreased to a relatively small value without affecting the operation of the termination circuit, the resistance value of the resistors $R_{11}$ and $R_{21}$ can be increased so that a large delay time is obtained. Therefore, the capacitance of the capacitor $C_{11}$ can be decreased so that the area occupied by the capacitor $C_{11}$ can be very small. Moreover, the termination circuit embodying the present invention uses a small number of circuit parts, and especially, each of the termination circuit units uses only one capacitor, for example $C_{11}$, so that the termination circuit occupies a relatively small area in an integrated circuit of a memory device.

**Claim**

A semiconductor memory device (Figure 5) having a plurality of memory cells (MC), each of the memory cells being connected between a word line (WL) and a hold line (HL), each of the word lines being selected by word address signals applied to the semiconductor memory device and being driven to different first or second potential levels with respect to a reference voltage in dependence upon the selected or non-selected condition of the word line, and each hold line having a hold line current source ($I_1 \ldots I_n$) connected thereto, the semiconductor memory device further comprising a termination circuit comprising:—

first transistors (T11, T12) each connected to one of the word lines for detecting a potential change of the word line with respect to a reference voltage, and each generating a detection signal when a change in the potential of the corresponding word line occurs;

delay circuits ($4_1$, $4_2$), each connected to a respective one of the first transistors for delaying a detection signal generated by the said transistor for a predetermined period;

and second transistors (T21, T22), each of which has its base connected to a respective one of the delay circuits and its collector connected to a respective one of the hold lines, each second transistor being turned on and off by the delayed detection signal from its respective delay circuit, whereby when a word line changes from a selected condition to a non-selected condition, the current flowing through a memory cell from the word line to the hold line continues after the said change and the potential fall time for the said word line is reduced;

characterized in that a common hold current source (30) is connected to the emitter of each of the second transistors, the said second transistors and the common hold current source thus forming a current switch, and in that each of the delay circuits comprises a resistor (e.g. R11) connected between an emitter electrode of the corresponding first transistor and the base electrode of the corresponding second transistor, and a capacitor (e.g. C11) connected between the base electrode of the corresponding second transistor and a reference voltage, and each of the said second transistors has its base connected through a further resistor (e.g. R21) to a common bias current source ($I_{BS}$).

**Patentanspruch**

Halbleiterspeichervorrichtung (Figur 5) mit einer Vielzahl von Speicherzellen (MC), von denen jede Speicherzelle zwischen einer Wortleitung (WL) und einer Halteleitung (HL) angeschlossen ist, jede der Wortleitungen durch Wortadressensignale ausgewählt wird, die der Halbleiterspeichervorrichtung zugeführt werden, und auf unterschiedlichen ersten und zweiten Potentialpegeln in Bezug auf eine Referenzspannung in Abhängigkeit von dem ausgewählten oder nicht ausgewählten Zustand der Wortleitung getrieben werden, und jede Halteleitung mit einer Halteleitungs-Stromquelle ($I_1$, ... $I_n$) verbunden ist, welche Halbleiterspeichervorrichtung ferner eine Beendigungsschaltung umfaßt, mit:—

erstern Transistoren (T11, T12), die mit einer der Wortleitungen verbunden sind, um eine Potentialänderung der Wortleitung in Bezug auf eine Referenzspannung zu erkennen, und jeweils ein Detektorsignal erzeugen, wenn ein Wechsel in dem Potential der entsprechenden Wortleitung eintritt;

Verzögerungsschaltungen ($4_1$, $4_2$), die mit einem entsprechenden der ersten Transistoren verbunden sind, um ein Detektorsignal, welches von dem genannten Transistor erzeugt ist, eine vorbestimmte Periode lang zu verzögern;

und mit zweiten Transistoren (T21, T22), deren Basis jeweils mit einer entsprechenden der Verzögerungsschaltungen verbunden ist und deren Kollektoren mit einer entsprechenden der Halteleitungen verbunden sind, wobei jeder zweite Transistor durch das verzögerte Detektorsignal von seiner jeweiligen Verzögerungsschaltung ein- und ausgeschaltet wird, wodurch dann, wenn eine Wortleitung von einem ausgewählten Zustand zu einem nicht ausgewählten Zustand wechselt, der Stromfluß nach der genannten Änderung durch eine Speicherzelle von der Wortleitung zu der Halteleitung weiterfließt und die Potentialabfallzeit für die genannte Wortleitung reduziert wird;

dadurch gekennzeichnet, daß eine gemeinsame Haltestromquelle (30) mit dem Emitter von jedem der zweiten Transistoren verbunden ist, die genannten zweiten Transistoren und die gemeinsame Haltestromquelle so einen Stromschalter bilden, und daß jede der Verzögerungsschaltungen einen Widerstand (z.B. R11) umfaßt, der zwischen einer Emitterelektrode des entsprechenden Transistors und der Basiselektrode des entsprechenden zweiten Transistors angeschlossen ist, und einen Kondensator (z.B. C11), der zwischen der Basiselektrode des entsprechenden zweiten Transistors und einer Referenzspannung angeschlossen ist, und jeder der genannten zweiten Transistoren eine Basis hat, die über einen weiteren Widerstand (z.B. R21) mit einer gemeinsamen Vorspannungsstromquelle ($I_{BS}$) verbunden ist.

**Revendication**

Dispositif de mémoire semiconducteur (figure 5) possédant plusieurs cellules de mémoire (MC), chacune des cellules de mémoire étant connectée entre une ligne de mot (WL) et une ligne de maintien (HL), chacune des lignes de mot étant sélectionnée par des signaux d'adresse de mot appliqués au dispositif de mémoire semiconducteur et étant excitée jusqu'à des premier ou deuxième niveaux de potentiel différents relativement à un potentiel de référence en fonction de l'état sélectionné ou non sélectionné de la ligne de mot, et chaque ligne de maintien étant connectée à une source de courant de ligne de maintien ($I_1$, ..., $I_n$), le dispositif de mémoire semiconducteur comprenant en outre un circuit de fin qui comprend:

des premiers transistors ($T_{11}$, $T_{12}$) connectés chacun à l'une des lignes de mot afin de détecter une variation de potentiel de la ligne de mot par rapport à une tension de référence, et produisant chacun un signal de détection lorsqu'une variation du potentiel de la ligne de mot correspondante s'est produite;

des circuits retardateurs ($4_1$, $4_2$) connectés chacun à l'un respectif des premiers transistors afin de retarder un signal de détection produit par ledit transistor pendant une durée prédéterminée;

et des deuxièmes transistors ($T_{21}$, $T_{22}$) qui sont chacun connectés par leur base à l'un respectif des circuits retardateurs et par leur collecteur à l'une respective des lignes de maintien, chaque deuxième transistor étant rendu conducteur et non conducteur par le signal de détection retardé venant de son circuit retardateur respectif, si bien que, lorsqu'une ligne de mot passe d'un état sélectionné à un état non sélectionné, le courant passant dans une cellule de mémoire, de la ligne de mot à la ligne de maintien, continue après ladite variation et le temps de descente du potentiel de ladite ligne de mot subit une diminution;

caractérisé en ce qu'une source de courant de maintien commune (30) est connectée à l'emetteur de chacun des deuxièmes transistors, lesdits deuxièmes transistors et la source de courant de maintien commune formant ainsi un commutateur de courant, et en ce que chacun des circuits retardateurs comprend une résistance (par exemple $R_{11}$) connectée entre une électrode d'émetteur du premier transistor correspondant et l'électrode de base du deuxième transistor correspondant, et un condensateur (par exemple $C_{11}$) connecté entre l'électrode de base du deuxième transistor correspondant et une tension de référence, et chacun desdits deuxièmes transistors est connecté par sa base à une source de courant de polarisation commune ($I_{BS}$) par l'intermédiaire d'une résistance supplémentaire (par exemple $R_{21}$).

# Fig. 1

# Fig. 2

# Fig. 4

# Fig. 3

## *Fig. 5*

# *Fig. 6*